# EUROPEAN PATENT APPLICATION

(11) **EP 4 826 447 A1**
(43) Date of publication of application: **21.10.2026**
(21) Application number: 25171499.4
(22) Date of filing: 18.04.2025
(51) Int. Cl.: G03F 7/00

(54) **FLUID HANDLING STRUCTURE**

(71) Applicant: ASML Netherlands B.V., 5500 AH Veldhoven (NL)
(72) Inventor: FAZLALI, Reza, 5500 AH Veldhoven (NL); WINKELS, Koen, Gerhardus, 5500 AH Veldhoven (NL); HENDRICKX, Michael, Eric, Kristin, 5500 AH Veldhoven (NL); SANDERS, Renatus, Hendrikus, Maria, 5500 AH Veldhoven (NL); TEN KATE, Nicolaas, 5500 AH Veldhoven (NL)
(74) Representative: ASML Netherlands B.V.

(57) **Abstract**

The present invention provides a fluid handling structure for an immersion lithographic apparatus, the fluid handling structure configured to confine immersion liquid to an immersion space between a bottom surface of the fluid handling structure and a surface of a substrate and/or a substrate support supporting the substrate, comprising a component comprising: at least one opening formed in a surface of the component and configured to supply or extract the immersion liquid; at least one channel in fluidic communication with the opening is defined in the component; wherein the component is made of glass and/or crystal.

## Description

### TECHNICAL FIELD

The present invention relates to a fluid handling structure and a method of manufacturing a fluid handling structure.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer). Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm.

Further improvements in the resolution of smaller features may be achieved by providing an immersion fluid having a relatively high refractive index, such as water, on the substrate during exposure. The effect of the immersion fluid is to enable imaging of smaller features since the exposure radiation will have a shorter wavelength in the fluid than in gas. The effect of the immersion fluid may also be regarded as increasing the effective numerical aperture (NA) of the system and also increasing the depth of focus.

The immersion fluid may be confined to a localized area, referred to as an immersion space, between a fluid handling structure of a fluid handling system and the substrate in the lithographic apparatus.

Existing fluid handling structures are generally made from metal like materials, with relative 'traditional' (fine precision milling, turning, 3D printing etc.) manufacturing methods. Many holes and channels are manufactured into multiple separate layers which are bonded and/or connected in different steps.

One of the main challenges is to accurately manufacture different supply and extraction channels including micron sized holes in the final bottom layer. Currently used technology is close to the limit of the required tolerances and minimum dimensions, which limits design (dimensions) space. Also, cleaning is relatively elaborate which all-in-all results in significant lead-times. Furthermore, there are additional challenges in providing improvements in thermally isolating the channels, all within a very small volume. The above-mentioned manufacturing of known fluid handling structures involves many consecutive processing steps, which result in a lead times of many months. Thus, there are also challenges involved in reducing manufacturing time.

In short, challenges in current fluid handling structure include, but are not limited to, thermal conditioning of immersion liquid and fluid handling structure, the fluid handling structure being prone to corrosion, limitations in precision, manufacturing limiting design freedom, and long lead-times.

### SUMMARY

It is an aim of the present invention to provide a fluid handling structure and a method for manufacturing a fluid handling structure which avoids or ameliorates at least one of the above-identified issues.

According to the present invention, there is provided a fluid handling structure for an immersion lithographic apparatus, the fluid handling structure configured to confine immersion liquid to an immersion space between a bottom surface of the fluid handling structure and a surface of a substrate and/or a substrate support supporting the substrate, comprising a component comprising: at least one opening formed in a surface of the component and configured to supply or extract the immersion liquid; at least one channel in fluidic communication with the opening is defined in the component; wherein the component is made of glass and/or crystal.

According to the present invention, there is provided a method of manufacturing a fluid handling structure for an immersion lithographic apparatus, the fluid handling structure configured to confine immersion liquid to an immersion space between a bottom surface of the fluid handling structure and a surface of a substrate and/or a substrate support supporting the substrate, the method comprising: providing a first component part and a second component part, wherein each of the first component part and the second component part is solid and is made of glass or crystal; using MEMS techniques to define an opening in a surface of the first component part and a channel in the first component part extending from the opening, and to define a further opening in a surface of the second component part and a further channel in the second component part extending from the second opening; etching to remove material from the first component part to form the opening and the channel and to remove material from the second component part to form the further opening and the further channel; bonding the first component part and the second component part to provide a component for forming the fluid handling structure, wherein the channel and the further channel are in fluidic communication.

According to the present invention, there is provided A method of manufacturing a fluid handling structure for an immersion lithographic apparatus by selective laser etching, the fluid handling structure configured to confine immersion liquid to an immersion space between a bottom surface of the fluid handling structure and a surface of a substrate and/or a substrate support supporting the substrate, the method comprising: providing a component for forming the fluid handling structure, wherein the component is solid and is made of glass or crystal, using a laser to define an opening in a surface of the component and a channel within the component extending from the opening; chemical etching to remove material from within the component to form the opening and the channel.

### BRIEF DESCRIPTION OF THE DRAWINGS

Embodiments of the invention will now be described, by way of example only, with reference to the accompanying schematic drawings, in which corresponding reference symbols indicate corresponding parts, and in which:
Figure 1 depicts the schematic overview of the lithographic apparatus;
Figures 2a, 2b, 2c and 2d each depict, in cross section, two different versions of a fluid handling system with different features illustrated on the left-hand side and the right-hand side of each version, which may extend around the complete circumference according to the prior art;
Figure 3 is a schematic view of openings at an underside of a fluid handling structure;
Figure 4 is a schematic view of a fluid handling structure;
Figure 5 is a schematic view of a fluid handling structure;
Figure 6 is a schematic of a cross-section of part of a fluid handling structure;
Figure 7 is a schematic of a cross-section of part of a fluid handling structure;
Figures 8a-8e provide a schematic view of steps of a method of manufacturing a fluid handling structure.

The features shown in the figures are not necessarily to scale, and the size and/or arrangement depicted is not limiting. It will be understood that the figures include optional features which may not be essential to the invention. Furthermore, not all of the features of the apparatus are depicted in each of the figures, and the figures may only show some of the components relevant for describing a particular feature.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

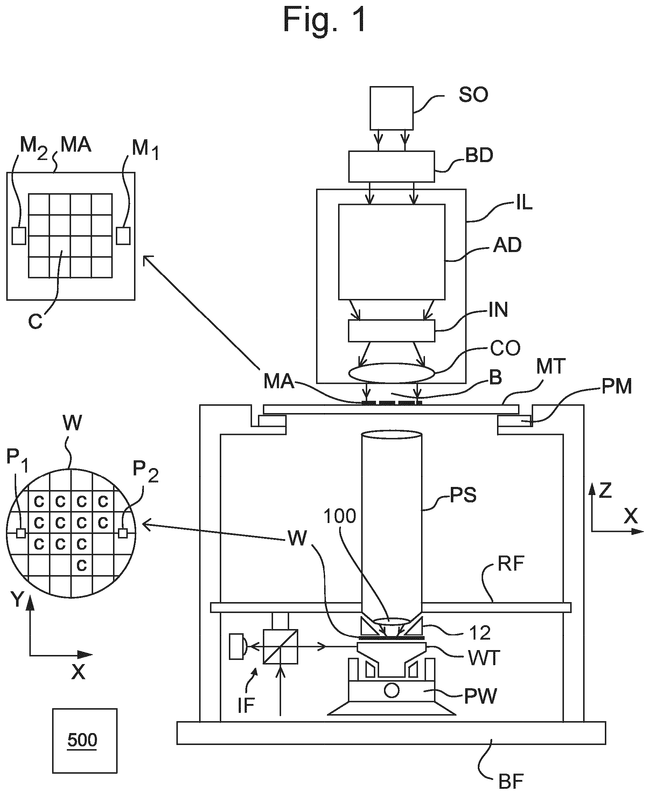

Figure 1 schematically depicts a lithographic apparatus. The lithographic apparatus includes an illumination system (also referred to as illuminator) IL configured to condition a radiation beam B (e.g., UV radiation or DUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a substrate table) WT constructed to hold a substrate (e.g., a resist coated wafer) W and connected to a second positioner PW configured to accurately position the substrate support WT in accordance with certain parameters, and a projection system (e.g., a refractive projection lens system) PS configured to project a pattern imparted to the radiation beam B by patterning device MA onto a target portion C (e.g., comprising one or more dies) of the substrate W. A controller 500 controls the overall operation of the apparatus. Controller 500 may be a centralised control system or a system of multiple separate sub-controllers within various sub-systems of the lithographic apparatus.

In operation, the illumination system IL receives the radiation beam B from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

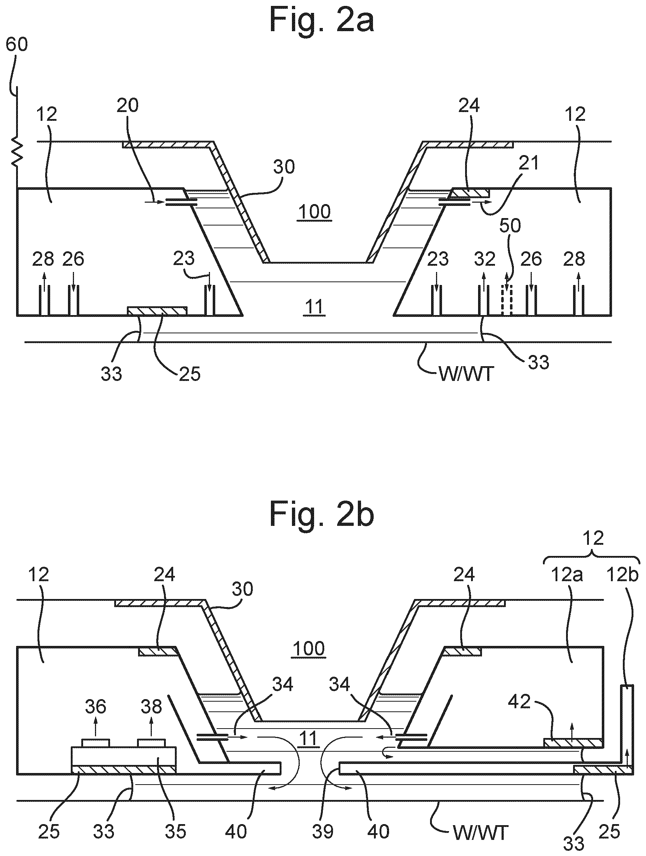

The lithographic apparatus is of a type wherein at least a portion of the substrate W may be covered by an immersion liquid having a relatively high refractive index, e.g., water, so as Figure 2a shows a fluid handling system comprising a fluid handling structure 12 around the bottom surface of the final element 100. The final element 100 has an inverted frusto-conical shape. The frusto-conical shape having a planar bottom surface and a conical surface. The frusto-conical shape protrudes from a planar surface and having a bottom planar surface. The bottom planar surface is the optically active portion of the bottom surface of the final element 100, through which the radiation beam B may pass. The final element 100 may have a coating 30. The fluid handling structure 12 surrounds at least part of the frusto-conical shape. The fluid handling structure 12 has an inner-surface which faces towards the conical surface of the frusto-conical shape. The inner-surface and the conical surface may have complementary shapes. A top surface of the fluid handling structure 12 may be substantially planar. The fluid handling structure 12 may fit around the frusto-conical shape of the final element 100. A bottom surface of the fluid handling structure 12 may be substantially planar and in use the bottom surface may be parallel with the facing surface of the substrate support WT and/or substrate W. Thus, the bottom surface of the fluid handling structure 12 may be referred to as a surface facing the surface of the substrate W. The distance between the bottom surface and the facing surface may be in the range of 20 to 500 micrometers, desirably in the range of 70 to 200 micrometers.

The fluid handling structure 12 extends closer to the facing surface of the substrate W and substrate support WT than the final element 100. The immersion space 11 is therefore defined between the inner surface of the fluid handling structure 12, the planar surface of the frusto-conical portion and the facing surface. During use, the immersion space 11 is filled with immersion liquid. The immersion liquid fills at least part of a buffer space between the complementary surfaces between the final element 100 and the fluid handling structure 12, in an embodiment at least part of the space between the complementary inner-surface and the conical surface.

The immersion liquid is supplied to the immersion space 11 through an opening formed in a surface of the fluid handling structure 12. The immersion liquid may be supplied through a supply opening 20 in the inner-surface of the fluid handling structure 12. Alternatively or additionally, the immersion liquid is supplied from a liquid supply opening 23 (which may be referred to as an under supply opening) formed in the bottom surface of the fluid handling structure 12. The liquid supply opening 23 may surround the path of the radiation beam B and it may be formed of a series of openings in an array or a single slit. The immersion liquid is supplied to fill the immersion space 11 so that flow through the immersion space 11 under the projection system PS is laminar. The supply of the immersion liquid from the liquid supply opening 23 additionally reduces the ingress of bubbles into the immersion space 11. This supply of the immersion liquid may function as a liquid seal.

The immersion liquid may be recovered from a recovery opening 21 formed in the inner-surface. The recovery of the immersion liquid through the recovery opening 21 may be by application of an underpressure; the recovery through the recovery opening 21 as a consequence of the velocity of the immersion liquid flow through the immersion space 11; or the recovery may be as a consequence of both. The recovery opening 21 may be located on the opposite side of the supply opening 20, when viewed in plan. Additionally or alternatively, the immersion liquid may be recovered through an overflow recovery 24 located on the top surface of the fluid handling structure 12. The supply opening 20 and recovery opening 21 can have their function swapped (i.e. the flow direction of liquid is reversed). This allows the direction of flow to be changed depending upon the relative motion of the fluid handling structure 12 and substrate W.

Additionally or alternatively, immersion liquid may be recovered from under the fluid handling structure 12 through a recovery opening 25 formed in its bottom surface. The recovery opening 25 may serve to hold a meniscus 33 of the immersion liquid to the fluid handling structure 12. The meniscus 33 forms between the fluid handling structure 12 and the facing surface and it serves as border between the liquid space and the gaseous external environment. The recovery opening 25 may be a porous plate which may recover the immersion liquid in a substantially single phase flow. The recovery opening in the bottom surface may be a series of fluid extraction openings 32 (which may be referred to as pinning openings) through which the immersion liquid is recovered. The fluid extraction openings 32 may recover the immersion fluid in a two phase flow.

Optionally radially outward, with respect to the inner-surface of the fluid handling structure 12, is a gas supply opening 26 (which may be referred to as a gas knife opening). Gas may be supplied through the gas supply opening 26 at elevated speed to assist liquid confinement of the immersion liquid in the immersion space 11. The supplied gas may be humidified and it may contain substantially carbon dioxide. Optionally radially outward of the gas supply opening 26 is a gas recovery opening 28 for recovering the gas supplied through the gas supply opening 26. In an embodiment, a step or a slope may be present between gas supply opening 26 and gas recovery opening 28. An additional fluid extraction opening may be formed in the step or slope between gas supply opening 26 and gas recovery opening 28.

Further openings, for example open to atmosphere or to a gas source or to a vacuum, may be present in the bottom surface of the fluid handling structure 12, i.e. in the surface of the fluid handling structure 12 facing the substrate W. An example of such an optional further opening 50 is shown in dashed lines on the right hand side of Figure 2a. As shown, the further opening 50 may be a supply or extraction member, which is indicated by the double-headed arrow. For example, if configured as a supply, the further opening 50 may be connected to a liquid supply or a gas supply as with any of the supply members. If the further opening 50 is configured as a supply and a step or a slope is present between gas supply opening 26 and gas recovery opening 28, gas supply opening 26 may be positioned at a higher location than the further opening 50 and gas recovery opening 28 may be located at a higher location than gas supply opening 26. In an embodiment, a step or a slope may be present between the further opening 50 and gas recovery opening 28. Alternatively, if the further opening 50 is configured as an extraction, the further opening 50 may be used to extract fluid, and may for example, be connected to atmosphere or to a gas source or to a vacuum. For example, the at least one further opening 50 may be present between gas supply opening 26 and gas recovery opening 28, and/or between fluid extraction openings 32 and gas supply opening 26. In Figure 2a, the further opening 50 is radially inward of the gas supply opening 26. Alternatively, the further opening 50 may be located radially outward of the gas recovery opening 28, or radially between the gas supply opening 26 and the gas recovery opening 28.

The two different versions of the fluid handling structure 12 of the left and right sides of Figure 2a pin the meniscus 33. The version of the fluid handling structure 12 on the right hand side of Figure 2a may pin the meniscus 33 at a position that is substantially fixed with respect to the final element 100, due to the fixed position of the fluid extraction opening 32. The version of the fluid handling structure 12 on the left hand side of Figure 2a may pin the meniscus 33 below the recovery opening 25, and thus the meniscus 33 may move along the length and/or width of the recovery opening 25. For the radiation beam B to be directed to a full side of the substrate W under exposure, the substrate support WT supporting the substrate W is moved relative to the projection system PS. To maximize the output of substrates W exposed by the lithographic apparatus, the substrate support WT (and so substrate W) is moved as fast as possible. However, there is a critical relative speed (often referred to as a critical scan speed) above which the meniscus 33 between the fluid handling structure 12 and the substrate W becomes unstable. An unstable meniscus 33 has a greater risk of losing immersion liquid, for example in the form of one or more droplets. Furthermore, an unstable meniscus 33 has a greater risk of resulting in the inclusion of gas bubbles in the immersion liquid, especially when the confined immersion liquid crosses the edge of the substrate W.

A droplet present on the surface of the substrate W may apply a thermal load and may be a source of defectivity. The droplet may evaporate leaving a drying stain, it may move transporting contamination such as a particle, it may collide with a larger body of immersion liquid introducing a bubble of gas into the larger body and it may evaporate, applying the thermal heat load to the surface on which it is located. Such a thermal load could be a cause of distortion and/or a source of a positioning error if the surface is associated with positioning of components of the lithographic apparatus relative to the substrate W being imaged. A formation of a droplet on a surface is therefore is undesirable. To avoid formation of such a droplet, the speed of the substrate support WT is thus limited to the critical scan speed at which the meniscus 33 remains stable. This limits the throughput of the lithographic apparatus.

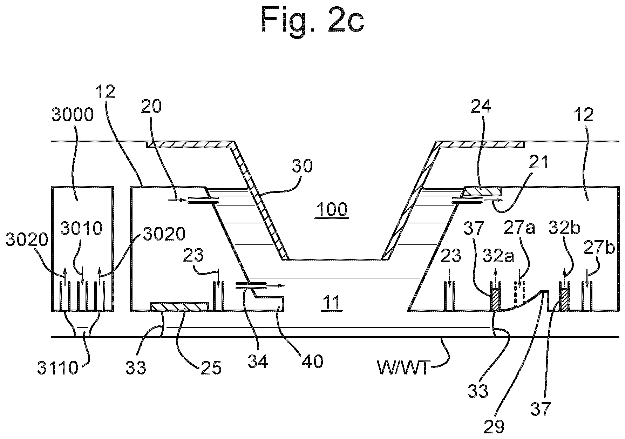

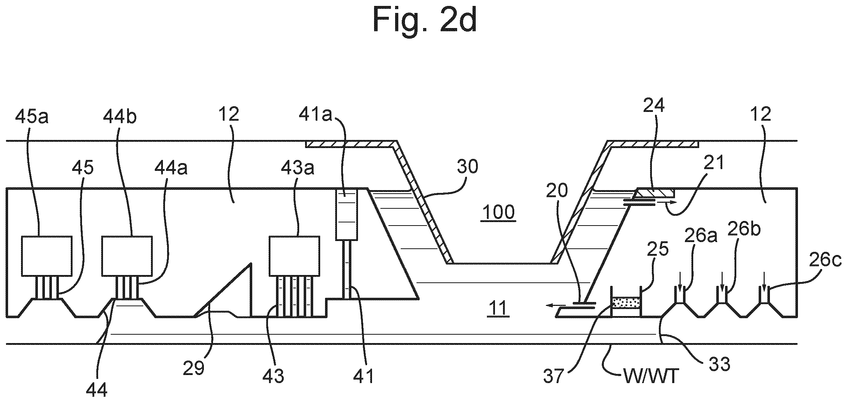

The left hand side of the fluid handling system in Figure 2a may comprise a spring 60. The spring 60 may be an adjustable passive spring configured to apply a biasing force to the fluid handling structure 12 in the direction of the substrate W. Thus, the spring 60 can be used to control the height of the fluid handling structure 12 above the substrate W. Such adjustable passive springs are described in US 7,199,874 which is herein incorporated by reference in its entirety. Other bias devices may also be appropriate, for example, using an electromagnetic force. Although the spring 60 is shown with the left hand side of Figure 2a, it is optional and does not need to be included with the other features of the left hand side of Figure 2a. The spring 60 is not shown on any of the other figures, but could also be included with the other variations of the fluid handling system described in relation to Figures 2a, 2b, 2c, or 2d.

Figure 2b shows two different versions of the fluid handling structure 12 on its left side and on its right side, which allow movement of the meniscus 33 with respect to the final element 100. The meniscus 33 may move in the direction of the moving substrate W. This decreases the relative speed between the meniscus 33 and the moving substrate W, which may result in improved stability and a reduced risk of breakdown of the meniscus 33. The speed of the substrate W at which the meniscus 33 breaks down is increased so as to allow faster movement of the substrate W under the projection system PS. Throughput is thus increased.

Features shown in Figure 2b which are common to Figure 2a share the same reference numbers. The fluid handling structure 12 has an inner surface which complements the conical surface of the frusto-conical shape. The bottom surface of the fluid handling structure 12 is closer to the facing surface than the bottom planar surface of the frusto-conical shape.

Immersion liquid is supplied to the immersion space 11 through supply openings 34 formed in the inner surface of the fluid handling structure 12. The supply openings 34 are located towards the bottom of the inner surface, perhaps below the bottom surface of the frusto-conical shape. The supply openings 34 are located around the inner surface, spaced apart around the path of the radiation beam B.

Immersion liquid is recovered from the immersion space 11 through recovery openings 25, in the bottom surface of the fluid handling structure 12. As the facing surface moves under the fluid handling structure 12, the meniscus 33 may migrate over the surface of the recovery opening 25 in the same direction as the movement of the facing surface. The recovery openings 25 may be formed of a porous member. The immersion liquid may be recovered in single phase. The immersion liquid may be recovered in a two phase flow. The two phase flow is received in a chamber 35 within the fluid handling structure 12 where it is separated into liquid and gas. The liquid and gas are recovered through separate channels 36, 38 from the chamber 35.

An inner periphery 39 of the bottom surface of fluid handling structure 12 extends into the immersion space 11 away from the inner surface to form a plate 40. The inner periphery 39 forms a small aperture which may be sized to match the shape and size of the radiation beam B. The plate 40 may serve to isolate the immersion liquid at either side of it. The supplied immersion liquid flows inwards towards the aperture, through the inner aperture and then under the plate 40 radially outwardly towards the surrounding the recovery openings 25.

The fluid handling structure 12 may be in two parts as shown on the right hand side of Figure 2b: a first component part 12a and a second component part 12b. The first component part 12a and the second component part 12b may move relatively to each other, mainly in a plane parallel to facing surface. The first component part 12a may have the supply openings 34 and it may have the overflow recovery 24. The second component part 12b may have the plate 40 and the recovery opening 25. The first component part 12a may have an intermediate recovery 42 for recovering the immersion liquid which flows between the first component part 12a and the second component part 12b.

The two different versions of the fluid handling structure 12 of Figure 2b thus allow for movement of the meniscus 33 in the same direction as the substrate W, enabling faster scan speeds and increased throughput of the lithographic apparatus. However, the migration speed of meniscus 33 over the surface of the recovery opening 25 in the fluid handling structure 12 of the left side of Figure 2b may be slow. The fluid handling structure 12 of the right side of Figure 2b allows for quicker movement of the meniscus 33, by moving the second component part 12b with respect to the first component part 12a and the final element 100. However, it may be difficult to control the intermediate recovery 42 so as to ensure that enough immersion liquid is provided between the first component part 12a and the second component part 12b to prevent contact therebetween.

Figure 2c shows two different versions of the fluid handling structure 12 on its left side and on its right side, which may be used to pin the meniscus 33 of the immersion liquid to the fluid handling structure 12 as described above in relation to Figures 2a and/or 2b. Features shown in Figure 2c which are common to Figures 2a and/or 2b share the same reference numbers.

The fluid handling structure 12 has an inner surface which compliments the conical surface of the frusto-chronical shape. The bottom surface of the fluid handling structure 12 is closer to the facing surface than the bottom planar surface of the frusto-chronical shape. Immersion liquid is supplied to the immersion space 11 delivered through an opening formed in a surface of the fluid handling structure 12. The immersion liquid may be supplied through a supply opening 34 in the inner surface of the fluid structure 12. Alternatively or additionally, the immersion liquid may be supplied through a supply opening 20 in the inner surface of the fluid structure 12. Alternatively or additionally, the immersion liquid is supplied through the liquid supply opening 23. The immersion fluid may be recovered via an extraction member, for example, via recovery opening 21 formed in the inner-surface and/or overflow recovery 24 and/or one or more openings in a surface of the fluid handling structure 12 as described below.

The two different versions of the fluid handling structure 12 of the left and right sides of Figure 2c pin the meniscus 33. The version of the fluid handling structure 12 on the right hand side of Figure 2c may pin the meniscus 33 at a position that is substantially fixed with respect to the final element 100, due to the fixed position of the recovery opening 32a. The version of the fluid handling structure 12 on the left hand side of Figure 2c may pin the meniscus 33 below the recovery opening 25, and thus the meniscus 33 may move along the length and/or width of the recovery opening 25.

As described above in relation to Figure 2b, an inner periphery of the bottom surface of fluid handling structure 12 may extends into the immersion space 11 away from the inner surface to form a plate 40 as shown on the left hand side. As described above, this may form a small aperture, and may isolate the immersion liquid at either side and/or cause immersion liquid to flow inwards towards the aperture, through the inner aperture and then under the plate 40 radially outwardly towards the surrounding the recovery openings 25. Although this features is shown on the left hand side in Figure 2c, it is optional in combination with the other features shown. Preferably, as shown on the left hand side, immersion liquid is supplied to the immersion space 11 through supply openings 34 formed in the inner surface of the fluid handling structure 12. The supply openings 34 are located towards the bottom of the inner surface, perhaps below the bottom surface of the frusto-conical shape. The supply openings 34 are located around the inner surface, spaced apart around the path of the radiation beam B. Alternatively or additionally, the immersion liquid may be supplied through a supply opening 20 in the inner surface of the fluid structure 12. Alternatively or additionally, the immersion liquid is supplied through the liquid supply opening 23. Although the supply openings 34 are the preferred liquid supply, any combination of supply openings 34, supply openings 20 and/or liquid supply openings 23 may be provided.

As shown on the left hand side of Figure 2c, a fluid handling system may comprise the fluid handling structure 12 as described above and a further device 3000. The fluid handling structure 12 may have an extraction member, such as recovery opening 25, and a liquid supply opening, such as the liquid supply opening 23. It will be understood that the fluid handling structure 12 may comprise any configuration as disclosed in relation to the left hand of Figure 2a, the right hand side of Figure 2a, the left hand side of Figure 2b, the right hand side of Figure 2b or (as described below) the right hand side of Figure 2c, in combination with the further device 3000.

The further device 3000 may otherwise be referred to as a droplet catcher. The further device 3000 is provided to reduce occurrence of liquid on the surface of the substrate W after the fluid handling structure 12 has moved over the surface. The further device 3000 may comprise a liquid supply member 3010 and at least one extraction member 3020. The at least one extraction member 3020 may be formed in a shape surrounding the at least one supply member 3010 in plan. The at least one liquid supply member 3010 may be configured to provide a further liquid to a space 3110 between at least a part of the further device 3000 and the surface of the substrate W. The further device 3000 may be configured to recover at least some of the liquid via the at least one extraction member 3020. The further device 3000 may be used to incorporate any liquid left on the surface of the substrate W with the liquid in the space 3110 and then use the further device 3000 to extract the liquid such that the amount of liquid remaining on the surface of the substrate W is reduced.

The further device 3000 is shown as a separate device from the fluid handling structure 12 in Figure 2c. The further device 3000 may be positioned adjacent to the fluid handling structure 12. Alternatively, the further device 3000 may be part of, i.e. integral to, the fluid handling structure 12.

The further device 3000 may be configured to provide a liquid to the space 3110 which is separate from the liquid provided by the fluid handling structure 12.

Additionally or alternatively, the fluid handling structure 12 may have the components as shown on the right hand side of Figure 2c. More specifically, the fluid handling structure 12 may comprise the at least one liquid supply member, two extraction members (e.g., recovery openings 32a and 32b) and two gas supply members (e.g., gas supply openings 27a and 27b) formed on the surface of the fluid handling structure 12. Gas supply opening 27a can be omitted, i.e. is optional. The at least one liquid supply member may be the same as the liquid supply opening 23 in the bottom surface of the fluid handling structure 12 described above or the supply opening 20 or liquid supply openings 34 formed on the inner surface of the fluid handling structure 12 described in relation to left hand side of Figure 2b. The liquid supply member, the extraction members and the gas supply members may be formed on the surface of the fluid handling structure 12. Specifically, these components may be formed on a surface of the fluid handling structure 12 facing the substrate W, i.e. the bottom surface of the fluid handling structure 12.

At least one of the two extraction members may comprise a porous material 37 therein. The porous material 37 may be provided within an opening, e.g., recovery opening 32a through which fluid handling structure 12 extracts fluid from below the fluid handling structure 12 and may recover the immersion liquid in a single phase flow. The other of the two extraction members, e.g., recovery opening 32b may recover the immersion fluid as a dual phase extractor. The porous material 37 does not need to be flush with the bottom surface of the fluid handling structure 12.

Specifically, the fluid handling structure 12 may comprise the liquid supply member (e.g., liquid supply opening 23), with a first extraction member (e.g., recovery opening 32a) radially outwards of the liquid supply member, and a first gas supply member (e.g., gas supply opening 27a) radially outwards of the first extraction member, and the second extraction member (e.g., recovery opening 32b) radially outwards of the first gas supply member, and a second gas supply member (e.g., gas supply opening 27b) radially outwards of the second extraction member. Similar to Figure 2a, further openings, for example open to atmosphere or to a gas source or to a vacuum, may be present in the bottom surface of the fluid handling structure 12 as described previously (in relation to the fluid handling structure 12).

For example, at least one further opening (not shown) may be provided in the bottom surface of the fluid handling structure 12. The further opening is optional. The further opening may be arranged between the first extraction member (e.g., recovery opening 32a) and the first gas supply member (e.g., gas supply opening 27a) as described in the arrangement above. Alternatively or additionally, the further opening may be arranged between the second extraction member (e.g., recovery opening 32b) and the second gas supply member (e.g., gas supply opening 27b) as described in the arrangement above. The further opening may be the same as further opening 50 described above.

Optionally, the fluid handling structure 12 comprises a recess 29. The recess 29 may be provided between the recovery opening 32a and recovery opening 32b or gas supply opening 27a and recovery opening 32b. The shape of the recess 29 may be uniform around the fluid handling structure 12 and may optionally contain an inclined surface. In the case of the recess 29 provided between the recovery opening 32a and recovery opening 32b, the gas supply opening 27b may be provided on the inclined surface as shown in Figure 2c. In the case of the recess 29 provided between the gas supply opening 27a and recovery opening 32b, the gas supply opening 27b may be provided on the inclined surface or a part of the bottom surface of the fluid handling structure 12 which is parallel to the surface of the substrate W. Alternatively, the shape of the recess 29 may vary around the circumference of the fluid handling structure 12. The shape of the recess 29 may be varied to alter the impact of gas supplied from the gas supply members on the fluid below the fluid handling structure 12.

Figure 2d shows, in its left and right halves, two different versions of the fluid handling structure 12. The fluid handling structure 12 of the left half of Figure 2d has a liquid injection buffer 41a, which holds a buffer amount of immersion liquid, and liquid injection holes 41 which supply immersion liquid from the liquid injection buffer to the immersion space 11. Outwardly of the liquid injection holes 41 are inner liquid recovery apertures 43 for conducting liquid to an inner recovery buffer 43a which is provided with a porous member. A recess 29 similar to that described relating to Figure 2c is provided outward of the inner liquid recovery apertures 43. Outward of the recess 29, in the lower face of the fluid handling structure 12 is a gas guiding groove 44 into which open outer recovery holes 44a. The outer recovery holes 44a lead a two-phase recovery flow to outer recovery buffer 44b which is also provided with a porous member. Outermost are gas sealing holes 45 which communicate between a gas sealing buffer volume 45a and the space underneath the fluid handling structure 12 to provide a gas flow to contain the immersion liquid.

The fluid handling structure 12 of the right half of Figure 2d has a supply opening 20 in the inner inclined face thereof. In the underside of the fluid handling structure 12 there are (from inner side to outer side) a recovery opening 25 provided with a porous member 37; a first gas supply opening 26a, a second gas supply opening 26b and a third gas supply opening 26c. Each of these openings opens into a groove in the underside of the fluid handling structure 12 that provides a buffer volume. The outermost part of the fluid handling structure 12 is stepped so as to provide a greater separation between the fluid handling structure 12 and the substrate W.

Figures 2a-2d show examples of different configurations which can be used as part of a fluid handling system. It will be understood that the examples provided above refer to specific extraction members and recovery members, but it is not necessary to use the exact type of extraction member and/or recovery member. In some cases different terminology is used to indicate the position of the member, but the same functional features may be provided. Examples of the extraction member referred to above include recovery opening 21, overflow recover 24, recovery opening 25 (possibly comprising a porous plate and/or the chamber 35), gas recovery opening 28, fluid extraction opening 32, recovery opening 32a, recovery opening 32b and/or the intermediate recovery 42. Examples of the supply member referred to above include supply opening 20, liquid supply opening 23, gas supply opening 26, gas supply opening 27a, gas supply opening 27b, and/or supply openings 34. In general, an extraction member used to extract/recover fluid, liquid or gas is interchangeable with at least any of the other examples used which extract/recover fluid, liquid or gas respectively. Similarly, a supply member used to supply fluid, liquid or gas is interchangeable with at least any of the other examples used which supply fluid, liquid or gas respectively. The extraction member may extract/recover fluid, liquid or gas from a space by being connected to an underpressure which draws the fluid, liquid or gas into the extraction member. The supply member may supply fluid, liquid or gas to the space by being connected to a relevant supply.

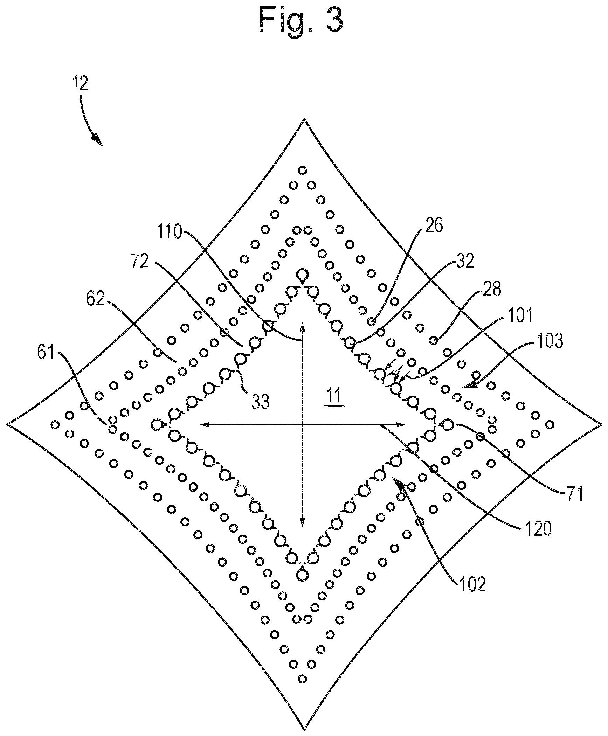

Figure 3 is a schematic view of openings at the underside of the fluid handling structure 12. As shown in Figure 3, in an embodiment the at least one fluid extraction opening 32 is arranged as a fluid extraction shape 102. In an embodiment the fluid handling structure 12 comprises a plurality of fluid extraction openings 32. The fluid extraction openings 32 may be arranged in an array. In an embodiment at least one fluid extraction opening 32 may be a slit opening (i.e. continuous). The fluid handling structure 12 may comprise one or more liquid supply openings 23 (not shown).

As shown in Figure 3, in an embodiment the fluid extraction shape 102 is defined by a plurality of sides 72 and corners 71. The corners 71 are between the plurality of sides 72. As shown in Figure 3, in an embodiment the corners 71 are geometrically relatively sharp corners. In an alternative arrangement, the corners 71 may be rounded. For example, the corners 71 may be the parts of the fluid extraction shape 102 that are at the most extreme ends of the fluid extraction shape 102 along the principal axes 110, 120 of the fluid extraction shape 102. The principal axes 110, 120 may be aligned with the major directions of travel of the substrate W under the fluid handling structure 12.

In the arrangement shown in Figure 3, the fluid extraction shape 102 may be substantially a diamond shape having concave sides. In an alternative arrangement, the fluid extraction shape 102 may be defined by smoother contours. For example, the fluid extraction shape 102 may be an ellipse. The extremes of the ellipse along the principal axes 110, 120 may form the corners 71 of the fluid extraction shape 102.

According to the present invention, there is provided a fluid handling structure 12 for an immersion lithographic apparatus. The fluid handling structure 12 is configured to at least partly confine immersion liquid to an immersion space 11 between a final (optical) element 100 and a substrate W (and/or a substrate support WT supporting the substrate W). The fluid handling structure 12 is configured to at least partly confine immersion liquid to the immersion space 11 between the bottom surface of the fluid handling structure 12 and a surface of the substrate W and/or a substrate support WT supporting the substrate W.

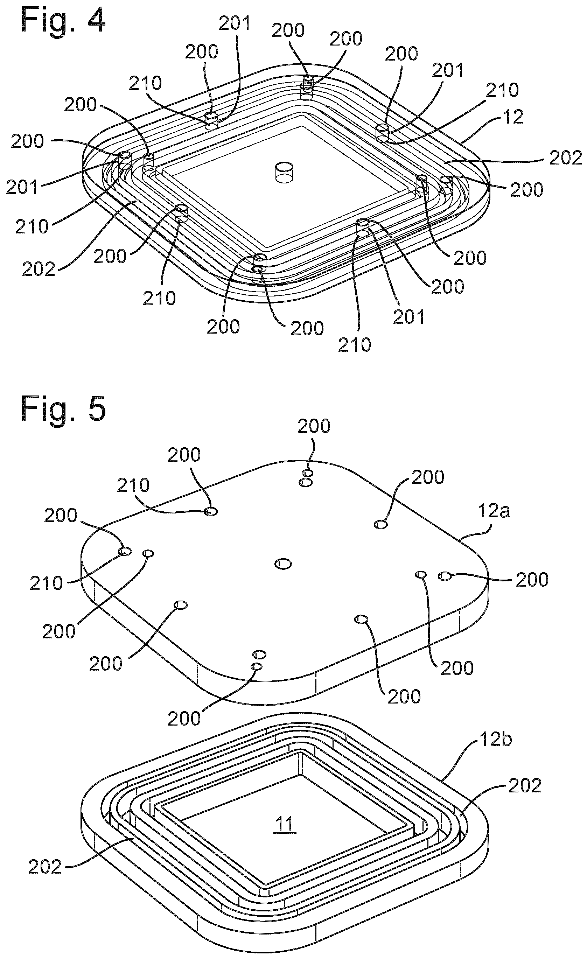

The fluid handling structure 12 comprises a component. The component forms the body of the fluid handling structure 12. The component is provided as a solid body, e.g. formed of a solid material, i.e. a solid block of material. The component may be monolithic. In other words, the component may form a solid body from a single component which forms the fluid handling structure 12, thus, the fluid handling structure 12 may be formed by a single, monolithic component. For example, a monolithic fluid handling structure is depicted in Figure 4, wherein the fluid handling structure 12 is formed by a single component in which multiple channels 201 and openings 210 have been formed, wherein the channels 201 can be seen through the fluid handling structure 12 as extending from the openings 210. The openings 210 may be formed on the bottom surface, i.e. on a surface for facing the substrate W and/or substrate table WT in use. The openings 210 and channels 201 may be the same as, or correspond to any of the supply and/or extraction features described above, e.g. in relation to Figures 2a, 2b, 2c and/or 2d (for example, including but not limited to, any extraction members referred to herein e.g. recovery opening 21, overflow recover 24, recovery opening 25 (possibly comprising a porous plate and/or the chamber 35), gas recovery opening 28, fluid extraction opening 32, recovery opening 32a, recovery opening 32b and/or the intermediate recovery 42, any supply members referred to herein, e.g. supply opening 20, liquid supply opening 23, gas supply opening 26, gas supply opening 27a, gas supply opening 27b, and/or supply openings 34).

As shown in Figure 4, the component may comprise at least one opening 200 on a surface other than the bottom surface. The openings 200 may be formed on an opposing surface to openings 210. The at least one channel 201 may extend between openings 210 and 200. The openings 200 may be formed on a surface opposite to the bottom surface. The openings 200 may be formed on the top surface (e.g. as shown in Figures 4 and 5). The openings 200 may be used for external/global supply and/or extraction of fluid to/from the fluid handling structure 12. In further detail, the openings 200 may, for example, be in communication with at least one channel (e.g. a coarse channel) for global supply and/or extraction towards 'outer-world'. The internal fluidic structure within the fluid handling structure 12 (e.g. via any internal channels 202) may be used to connect the openings 200 on the top surface to the openings 210 on the bottom surface, wherein the openings 210 and channels 210 may form a fine structure, e.g. the openings 210 and channels 201 may be the same as, or correspond to any of the supply and/or extraction features described above, e.g. in relation to Figures 2a, 2b, 2c and/or 2d (for example, including but not limited to, any extraction members referred to herein e.g. recovery opening 21, overflow recover 24, recovery opening 25 (possibly comprising a porous plate and/or the chamber 35), gas recovery opening 28, fluid extraction opening 32, recovery opening 32a, recovery opening 32b and/or the intermediate recovery 42, any supply members referred to herein, e.g. supply opening 20, liquid supply opening 23, gas supply opening 26, gas supply opening 27a, gas supply opening 27b, and/or supply openings 34).

As described in further detail below, the fluid handling structure 12 may be formed by a plurality of components/component parts, e.g. may include at least one additional component part to form the fluid handling structure 12, for example as shown in Figure 5.

The component is made of glass and/or crystal. Using glass and/or crystal is very beneficial due to the intrinsic material properties, such as low thermal conductivity, high mechanical strength, high chemical inertness (e.g. corrosion resistance), low coefficient of thermal expansion (CTE), high stiffness, and broad available spectrum of coatings applicable (e.g. to control wetting, thermal and/or electrical sensing/control (e.g. Pt), soft/hard polymers).

For example, the component may be made of any one of fused silica, silicon, borosilicate, sapphire (e.g. crystalline sapphire), or Yttrium aluminium garnet (YAG), ULE, BF33, D263, NK5, SF2, Zerodur, AF45, Eagle XG, quartz.

Forming the component using the above described materials is beneficial in that these materials may be used to form ultra-flat surfaces. For example, at least one surface of the fluid handling structure 12 may be formed with total flatness variations minimized down to microns, or even tenths of micrometers. This may be particularly useful for the bottom surface of the component, i.e. the surface of the component for facing the substrate W and/or a substrate support WT supporting the substrate W.

As mentioned with reference to Figures 2a-2d and 3, the fluid handling structure 12 confines the immersion fluid to an immersion space 11 between a final element 100 and a substrate W. The substrate W is moved relative to the fluid handling structure 12 during a lithographic processing step.

When a substrate W is moved relative to the fluid handling structure 12, the substrate W has a receding side and an advancing side. The receding side is the part of the substrate W which is moving away from the centre of the immersion space 11, and the advancing side is the part of the substrate which is moving towards the centre of the immersion space 11. This also means that when the fluid handling structure 12 is moved relative to the substrate W, the fluid handling structure 12 has a receding side and an advancing side. In this case, the receding side of the fluid handling structure 12 is the part of the fluid handling structure 12 which is moving towards the centre of the immersion space 11, and the advancing side is the part of the fluid handling structure 12 which is moving away the centre of the immersion space 11. (The above statements apply only before the centre of immersion space. If either is moved after the centre of immersion space both advancing side and receding side are away from the centre of immersion space.)

The fluid handling structure 12 comprises at least one opening 210 formed in a surface of the component and configured to supply or extract the immersion fluid. The fluid handling structure 12 comprises at least one channel 201 communicating with the opening defined in the component. In other words, a channel 201 formed within the component is in fluidic communication with the opening 210. In this way, immersion fluid can be supplied to, or extracted via, the at least one opening 210.

The at least one opening 210 may be the same as the at least one liquid supply opening 23 described above, as shown in, for example, Figure 2a. Thus, in an embodiment the fluid handling structure 12 comprises at least one liquid supply opening 23. The liquid supply opening 23 is configured to supply immersion liquid to the immersion space 11. As described above, the liquid supply opening 23 may surround the path of the radiation beam B and it may be formed of a series of openings in an array or a single slit. In an embodiment the fluid handling structure 12 comprises a plurality of the liquid supply opening 23. The liquid supply openings 23 may be arranged to form a geometrical shape, for example a circle, an oval, or a diamond. Additionally or alternatively, the at least one opening 210 may be the same as any alternative supply member described herein.

Additionally or alternatively, the fluid handling structure 12 comprises at least one fluid extraction opening 32, for example, as shown in Figure 2a. The fluid extraction opening 32 may be radially outwards of the liquid supply opening 23. The fluid extraction opening 32 is configured to extract fluid from the immersion space 11. Immersion fluid may be extracted from the substrate W with the fluid extraction opening 32. This may be done using a two-phase flow. The fluid extraction opening 32 may be configured to extract gas and liquid. Additionally or alternatively, the at least one opening 210 may be the same as any alternative extraction member described herein.

Thus, the fluid handling structure 12 may comprise multiple openings 210, each with a corresponding channel 201 communicating with the opening 210 and defined in the component, wherein at least one opening 210 is configured to supply immersion liquid and at least one opening 210 is configured to extract immersion fluid. Thus, the component may comprise multiple openings 210, each with a corresponding channel 201 communicating with the opening 210 and defined in the component, comprising at least one liquid supply opening 23 (with a corresponding fluid supply channel for supplying immersion liquid) and at least one fluid extraction opening 32 (with a corresponding fluid extraction channel for extracting immersion fluid).

The fluid handling structure 12 (e.g. the component) may comprise additional fluid supply and/or extraction openings/channels, e.g., gas supply opening 26 and/or gas recovery opening 28.

In an embodiment, the fluid handling structure 12 comprises at least one gas supply opening 26, for example, as shown in Figure 2a. In an embodiment the fluid handling structure 12 comprises a plurality of gas supply openings 26. The gas supply opening 26 may be radially outwards of the fluid extraction opening 32. The gas supply opening 26 is configured to supply a gas to the immersion space 11. In an embodiment at least one of the gas supply openings 26 may be a slit opening (e.g. a continuous linear opening). Alternatively, the gas supply openings 26 may be substantially round, as shown in Figure 3, for example.

As will be understood, when the fluid handling structure 12 is provided by a monolithic component, the openings 210 and channels 201 described above/herein are provided/formed as part of the component.

As shown in Figure 3, in an embodiment the at least one gas supply opening 26 is arranged as a gas supply shape 103. In an embodiment the gas supply shape 103 surrounds the fluid extraction shape 102. As shown in Figure 3, in an embodiment the gas supply shape 103 matches the fluid extraction shape 102. The gas supply shape 103 may be substantially the same as the fluid extraction shape 102 except that the gas supply shape 103 is bigger than the fluid extraction shape 102. However, it is not essential for the gas supply shape 103 to match the fluid extraction shape 102. In an alternative embodiment, the gas supply shape 103 may be shaped differently from the fluid extraction shape 102. For example, the gas supply shape 103 may be circular, oval shaped, square or rectangular.

As shown in Figure 3, in an embodiment the gas supply shape 103 comprises sides 62 and corners 61 between the sides 62. The corners 61 of the gas supply shape 103 may correspond to the extremes of the gas supply shape 103 along the principal axes 110, 120.

In an embodiment each fluid extraction opening 32 is configured to extract a mixture of liquid and gas, i.e., two phase flow. The liquid is extracted from the immersion space 11. The gas is extracted from the atmosphere on the other side of the fluid extraction openings 32 to the liquid. This creates a gas flow 101 as illustrated by arrows. The gas flow 101 is effective to pin the meniscus 33 between the fluid extraction openings 32 substantially in place. The gas flow 101 helps maintain the liquid confined by momentum blocking, by a gas flow induced pressure gradient and/or by drag (shear) of the gas flow 101 on the liquid.

As shown in Figure 2a, for example, in an embodiment the fluid handling structure 12, and particularly the component, is configured such that the openings are separated from the substrate W and/or substrate support WT by a separation distance. The separation distance may vary at different locations of the fluid handling structure 12.

As would be understood by the skilled person, forming the openings and channels in the component formed of solid glass and/or crystal may not be possible using previously known methods of forming fluid handling structures 12 given that entirely different materials were previously relied on.

The at least one opening 210 and the at least one channel 201 can be formed in the component using selective laser etching (SLE) for transparent materials. The selective laser etching technology can be used to produce at least one channel 201 and other features, such as at least one hole, opening 210 and/or slit, inside a material. The materials described above, i.e. glass and crystal, are well suited for SLE. SLE can be used throughout the component, and can be used to form openings 200 on the top surface also.

Details relating to selective etching (e.g. materials, etchants, etc.) may be selected based on known literature on selective etching, for example, "Optimization of selective laser etching (SLE) for glass micromechanical structure fabrication" by Butkutė et al, Opt. Express 29, 23487-23499 (2021), DOI: https://doi.org/10.1364/OE.430623, which is hereby incorporated by reference in its entirety.

Using selective laser etching is beneficial in that it can result in low roughness (for example only 0.2-1 um RMS). Thus, the selective laser etching may provide improved surface finish which may lead to a possible improvement of yield. For example, the surface produced with the SLE process may remain flat (same as the starting condition), whereas other methods may result in non-flatness and therefore require extra post work and attention. Additionally, the material removal dimension is small (for example only, approximately 1 mu (voxel size)) with little to no residual stress or chipping of the material.

Using selective laser etching (SLE) for fabrication of the main body of the fluid handling structure (or part of the main body) is beneficial in that SLE is very versatile, the design space is large on a wide variation of length scales mm-scale down to approximately 5 micron, while keeping high precision and small tolerances. Selective laser etching is beneficial in that it allows for full 3-D design freedom within a transparent bulk material without changing the original bulk and surface properties (e.g. transparency, surface-roughness and mechanical properties). Using selective laser etching is beneficial in that any desired shape (e.g. for the at least one opening 210 and/or channel 201) may be formed and precision of between approximately 1 - 100 micron voxel size (note: a voxel can be spherical and cylindrical, possible shape relates to optical shaping options) can be achieved via, for example, laser beam shaping. In this way, the cross-section of the at least one opening 210 and/or channel 201 may be precisely controlled, e.g. to control the width/diameter and/or the cross-sectional shape (which may be circular, but could be other shapes also).

Example available geometries and structures include, but are not limited to, main supply and extraction channels, burrowed (connection / interposer) channels, membranes (for sensing and/or actuation), voids, slits, slots (square holes) to micron sized holes. Using selective laser etching is particularly beneficial in that it provides control over shaping of openings 210 and channels 201 (e.g. hole shaping in depth direction) to enable and control for example critical flows, which may be relevant for various fluid supplies and/or extractors/recoveries. Selective laser etching enables tilted channels 201 (and any other shaped opening 210, e.g. for supply and/or extraction/recovery) over large angle variations, and which optionally, may vary with position.

Using selective laser etching may be beneficial in that the fluid handling structure 12 can be manufactured more easily and with a relatively short lead time. For example, using selective laser etching may provide a much simpler option than previously used methods. For example, using laser etching may provide a relatively short lead time (compared to prior known methods of manufacture) for at least the main body of the fluid handling structure 12 (i.e. the component containing some or all small supply and extraction holes/channels) because the method is capable of carrying out many direct shaping steps at once. Thus, the expected manufacturing time for the fluid handling structure 12 of the present invention is expected to be significantly lower that previous manufacturing techniques, e.g. in the order of weeks rather than months.

For completeness, it is possible for a skilled person to determine if the component is made by selective laser etching (SLE) for a number of reasons. For example, providing 3-D structures inside a transparent bulk material (e.g. within solid glass or crystal) cannot be formed by most methods. Furthermore, the skilled person would be able to tell due to the size of the features and the surface roughness. Furthermore, certain features, such as tilted channels, can be obtained via SLE which would not be possible via other methods, and as such, the skilled person would be able to determine that such a channel is formed by SLE. It is noted that bulk material (i.e. solid glass or crystal) is distinguishable from material which is formed, for example, by 3-D printing.

A diameter of the at least one opening 210 may be of any appropriate size. Forming the fluid handling structure 12 using the methods/processes described herein is beneficial in that openings 210 (and channels 201) of relatively small size can be formed in the fluid handling structure 12. For example, at least one opening 210 may have a diameter of greater than or equal to approximately 5 micrometers, or greater than or equal to 10 micrometers, or greater than or equal to 20 micrometers. The diameter of at least one opening 210 may be between approximately 5 to 20 micrometers, or between approximately 5 to 10 micrometers. A corresponding channel 201, e.g. which extends from an opening 210, may have the same diameter as the opening 210. Thus, at least one channel 201 may have a width (e.g. diameter) of greater than or equal to approximately 5 micrometers, or greater than or equal to 10 micrometers, or greater than or equal to 20 micrometers. The diameter of at least one channel 201 may be between approximately 5 to 20 micrometers, or between approximately 5 to 10 micrometers. Openings 210 and/or channels 201 of this size are more easily obtainable due to the methods/processes disclosed herein, e.g. using selective laser etching. It is noted that openings 200 on a top surface as shown in Figures 4 and 5 may have same diameter as described herein for the openings 210. The channels 201 may have fillet sizes which are the same or smaller than the opening dimensions. Although SLE has a micron-sized accuracy and capability, the openings 210 and channels 201 of fluid handling structures 12 may be much greater (e.g. of the order of tens of microns (e.g. 50 microns or more) up until tens of millimetres). Thus, SLE may be particularly useful in providing micron accuracy even for larger-scale products.

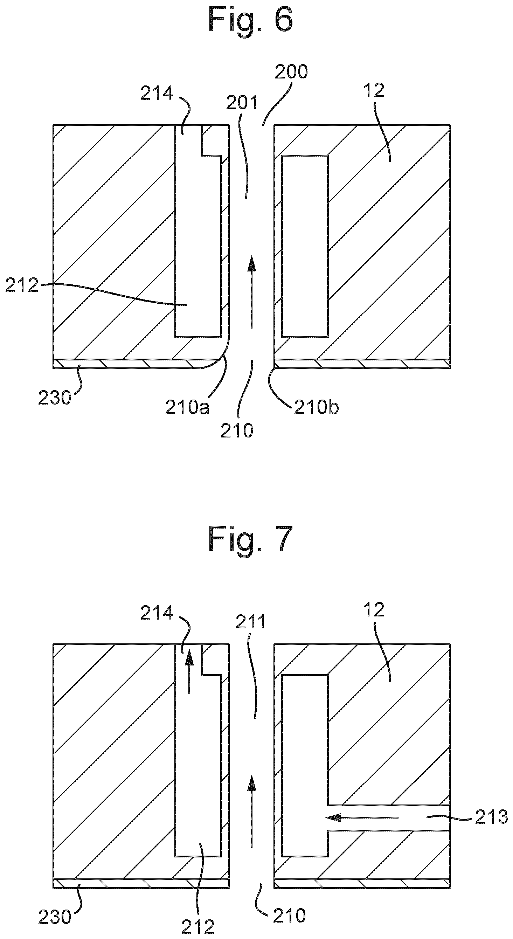

In an embodiment, the at least one opening comprises a slit and a radius of curvature on one edge of the slit is different to a radius of curvature on an opposing edge of the slit. For example, as shown in Figure 6, a first side 210a of the opening has a curved corner, whereas a second side 210b of the opening (opposite the first side 210a) has a sharper corner (e.g. even 90 degrees). In other words, the first corner 210a has a greater radius of curvature that the second corner 210b. In other words, the curvature at the edges of the slit can be selected, and may be different from each other. In this way, the curvature of exit and/or entrance for supplying and/or extraction respectively (depending on how the opening is used) can be selected. In other words, the shape/angle of around the edge of the opening can be selected to affect/bias an angle of the flow on entry or exit to the opening. This enables (amongst others benefits), a biased directional outflow for example in a fluid outflow from a slit (or inflow if fluid extraction into slit). Typical challenge for a slit flow is avoiding waviness in the direction of the outflow pattern (e.g. varying non-perpendicular outflow or instable flows). A bias to one outflow direction can be imposed via two different radii of curvature on each outflow edge as the flow can be turned toward a single (preferred) direction. It is noted that although the opening having different radii of curvature is shown in figure 6, it is not necessary to provide this feature in combination with other features shown in figure 6 (i.e. it may not be provided), and the opening having different radii of curvature may be provided in combination with other features and/or figures described herein.

The fluid handling structure 12 may comprise at least one connection portion in the component for attachment to another part. The at least one connection portion may form, or be part of, the at least one opening 200. For example, the at least one connection portion may be used for attachment to an external part. For example, the at least one connection may be used to form an "outer-world-flow" connection. In other words, the at least one connection may be used to fluidly connect at least one channel 201 in the fluid handling structure 12 to a fluid conduit and/or channel 201 external to the fluid handling structure 12. The at least one connection portion may be formed in the body of the component, e.g. may be formed by a recess or opening. The at least one component may be formed on an outer surface of the component. The at least one connection portion may comprise a threaded opening defined on an outer surface of the component. For example, a connector, e.g. a threaded connector such as a screw type connector, may be attached to the fluid handling structure 12 via the at least one connection. Such a connection might be particularly beneficial in providing a leak tight seal at a relatively high overpressure. The at least one connection may be used for mechanical mounting (i.e. without any fluidic function). In this case, the location my preferably be at an inner surface, if for example it is used to combine two component parts (described below), for example, via a mounting bolt (e.g. mechanical mounting).

The component may comprise a plate region (e.g. plate 40 as shown in Figures 2b, 2c and 2d). A thickness of the plate region may be between approximately 0.2 mm and 20 mm, preferably between approximately 0.5 mm and 10 mm.

In an embodiment, the plate region comprises at least one opening and a corresponding channel. In other words, at least one of the openings and channels (as in any of the variations described herein), may be formed within the plate region. The plate region may be beneficial in enhancing (i.e. increasing) bubble travel length with the goal to lower chance of bubbles in exposure zone. In other words, the distance a bubble must travel (e.g. from near the meniscus 33 where a bubble is most likely to form) to the exposure zone (i.e. below final element 100) may be larger due to the plate region, which may decrease the likelihood of the bubble affecting the radiation beam B passing through the immersion liquid.

In particular, the use of selective laser etching (or other method which is capable of achieving small openings/channels) enables fluidic channels in the thin part of the component forming the plate 40. For example, this means that an opening and channel may be formed in the plate region which is used for extracting fluid.

For example, extraction opening 32 may be positioned in the plate region, for example, on the left hand side of Figure 2b instead of recovering opening 25. Providing an opening for fluid extraction (and a corresponding channel) in the plate region allows the meniscus 33 to be located radially inwards. This allows to reduce the effective wetted area (as the meniscus 33 would be radially inwards, i.e. to the right in the left hand side of Figure 2b) which could reduce the wetted area of the substrate W and/or a substrate support WT supporting the substrate W. This may be beneficial in lowering disturbance forces and increasing critical scanning velocity.

Additionally or alternatively, a supply for the immersion liquid may be positioned in the plate region, for example, on the on the left hand side of Figure 2b instead of, or in addition to, supply opening 34. It is noted that any appropriate supply and/or extraction features described above, e.g. as described in relation to Figures 2a, 2b, 2c and/or 2d, may be positioned in the plate region.

The component may comprise at least one thermal insulator and/or thermal conditioner. For example, the thermal insulator and/or thermal conditioner may be adjacent to at least part of the at least one channel 201, for example as shown in Figures 6 and 7. It is noted that the thermal insulator and/or thermal conditioner may be provided elsewhere in the component, e.g. for insulating or conditioning another part of the component. For example, the thermal insulator and/or thermal conditioner may be provided between other parts of the component, e.g. in between internal channels within the component, e.g. between internal channels 202 (which may otherwise be described as gutters in Figures 4 and 5). The thermal insulator and/or thermal conditioner may comprise a thermal channel 212 in fluidic communication with an inlet and/or outlet configured to apply a vacuum, conditioning fluid, or insulating fluid within the thermal channel 212. The thermal insulator and/or thermal conditioner may surround at least part of the at least one channel. The thermal insulator and/or thermal conditioner may be a concentric channel (or similar). For example, as depicted in Figure 6, the thermal insulator and/or thermal conditioner may comprise a concentric thermal channel 212, and may be configured to apply a vacuum to the concentric thermal channel 212. In this case, the concentric thermal channel 212 may have a single opening (forming an inlet/outlet) 214 via which the vacuum can be applied or via which insulating fluid be supplied and extracted. The vacuum or insulating fluid may be used to (further) reduce or minimize heat transfer between fluid in the at least one channel 201 and the surroundings. For example, as depicted in Figure 7, the thermal insulator and/or thermal conditioner may comprise a concentric thermal channel 212 for conditioning fluid. In this case, the concentric thermal channel 212 may have an inlet channel 213 and an outlet channel 214 so that conditioning fluid can pass through the concentric thermal channel 212. The conditional fluid can be used to provide an outer temperature conditioning channel to affect the temperature of fluid in the at least one channel 201. The thermal channel 212 can be used to supply / extract / add e.g. thermal mass, flow of constant temperature etc.. The thermal channel 212 may otherwise be referred to as a volume, void, space. In the instance of providing a vacuum (e.g. as in figure 6), the thermal channel 212 may be a fixed volume inside the body/component without connecting to the outside world when formed, e.g. by using an opening somewhere to create the vacuum or vacuum as a permanent pocket created in the bonding process which is then sealed to form the fixed volume without connecting to the outside world.

At least a portion of a surface of the fluid handling structure 12 may be provided with a coating 230, for example as shown in Figures 6 and 7. In particular, at least a portion of a surface of the component may be provided with the coating 230. As shown in Figures 6 and 7, the coating 230 may be on a surface comprising at least one opening 210. For example, the coating 230 may be on a bottom surface of the component (i.e. configured to face the substrate W and/or a substrate support WT supporting the substrate W).

The coating 230 may be applied to the fluid handling structure 12 amongst others to enable thermal and/or electrical sensing (e.g. Pt -- and/or thermal and/or electrical control), control stiffness surface interface (e.g. soft/hard), control wettability and/or surface roughness. Surface wettability can be controlled via surface finish, for example hydrophobicity can be defined with chemical coatings (HMDS, Teflon etc.) or physical surface structures, e.g. from nm-size up to several ~um-size. Examples (amongst others) of benefits of surface control include: (1) better control over wetted (hydrophilic) area and non-wetted (hydrophobic) area, and thus better immersion liquid confinement; (2) control heat load of (two phase)extraction/supply; and (3) for improving stratified flow through a channel the liquid contacting surface should be made/kept hydrophilic and the gas contacting surface super-hydrophobic. It is noted that the coating may be provided on the outer surface, e.g. the bottom surface. However, the coating is not limited to the outer surface. Additionally or alternatively, the coating may be provided on at least one inner surface of the fluid handling structure, e.g. a surface of at least one channel. This may be particularly useful for improving stratified flow through the channel as described above.

It is noted that Figures 6 and 7 show a thermal channel 212 and the coating 230. However, it is not necessary to provide both on the same component. For example, a component may comprise a form of thermal insulator and/or thermal conditioner, e.g. as described above/shown in the figures, without the coating 230 as shown, or with coating 230 on a different part of the component. For example, a component may comprise the coating 230, e.g. as described above/shown in the figures, without a thermal insulator and/or thermal conditioner.

In an embodiment, the component is transparent, and the fluid handling structure 12 further comprises a sensor (not shown) configured to take a measurement through the component. The sensor may be used, in view of the material transparency, to enable diagnostics / performance improvement (for feedback control, e.g. routing adjustments) in relation to defectivity (bubble or droplet). For example, the sensor may be used for detection of entrapped bubbles moving towards exposure zone (i.e. which may cause defects). The sensor may use light and/or radiation (heating). For example, the sensor may be/comprise a miniature camera, laser or LED diodes with transmission reflectance measurement techniques. Additionally or alternatively, this technique enables other ideas such as acoustic sensing and actuation. For example, small pockets with a membrane can be manufactured to allow acoustic sensing and actuation via a local e.g. piezo electric actuation (e.g. PMUT) or capacitive (CMUT). For example, for acoustic sensing and actuation, a layer (or membrane) may be in contact with immersion liquid, wherein the layer (or membrane) is piezo connected (and e.g. backed with bulk material or prestressed) or has a capacitive micromachined ultrasonic transducers (CMUT) adjacent (e.g. directly above) the layer (or membrane).

In an embodiment of the present invention, a method is provided of manufacturing a fluid handling structure 12 for an immersion lithographic apparatus by selective laser etching. The fluid handling structure 12 may be as described in any of the above embodiments. The fluid handling structure 12 is configured to confine immersion liquid to an immersion space 11 between a bottom surface of the fluid handling structure 12 and a surface of a substrate W and/or a substrate support WT supporting the substrate W.

In an embodiment, the method comprises providing a component for forming the fluid handling structure 12, wherein the component is solid and is made of glass or crystal. In other words, a solid block of material, i.e. glass or crystal, is provided in which the at least one opening 210 and channel 201 can be formed. The method comprises using a laser to define the opening 210 in a surface of the component and a channel 201 within the component extending from the opening 210. In this way, material to be removed from the component is exposed with a laser to change its properties. For example, the opening 210 may be formed in the bottom surface of the component. In this embodiment, the method comprises chemical etching to remove material from within the component to form the opening 210 and the channel 201. Thus, the method comprises a step of removing material from the component which is exposed to the laser (i.e. with altered properties). This material can be removed through an opening 210 by etching. Since the laser exposed material has a significant faster etching rate, approximately only the laser exposed volume will be etched away over the total etching time applied. Because laser and etching accuracies are very high, micrometer sized features can be made with small tolerances. Any appropriate etchant may be used. For example only, the etchant may be hydrofluoric acid (HF) and/or Potassium Hydroxide (KOH). The component/fluid handling structure 12 formed by the method described herein may have any combination of features as described above.

The material used to form the component by selective laser etching shall be transparent for the laser and is etchable. Selective laser etching may be applied to appropriate materials, i.e. many types of glasses and crystals. For example, the component may be made of fused silica, borosilicate, sapphire (e.g. crystalline sapphire), or Yttrium aluminium garnet (YAG), ULE, BF33, D 263, N-K5, SF2, Zerodur, AF45, Eagle XG, quartz.

An advantage of using selective laser etching is that it may improve cleanliness, for example, because the processing method is contactless (i.e. by using a laser), and because the subsequent etching may be the only component contact process (etching), which is cleaning in itself.

An advantage of using selective laser etching is that the component may be monolithic. Using this technique, the fluid handling structure 12 can be manufactured as one monolithic part, i.e. as a single component, including the desired openings 210 and/or channels 201. For example, including small scale (micro- and mm-sized) features for extraction / supply connected to macroscopic main channels. The macroscopic channels may serve to scale up towards final main flow system connections (i.e. to at least one outer-world-connection).

It is noted that although there may be benefits in being able to form the fluid handling structure 12 as a single component, this is not a necessity, and variations including multiple components (e.g. multiple layers) are described below. Even if multiple components are used to form a fluid handling structure 12, the same method may be used to form the opening 210 and/or channel 201 in at least one of the components/component parts, and additional steps of joining the components may be additionally included. Although it is noted that one component may be formed by the methods described herein (e.g. using SLE) and at least one other component may be formed by an alternative method (i.e. another manufacturing technique, for example only, simple laser cutting)

The method may comprise forming the at least one opening 210 have a diameter and/or width as described above. Similarly, the method may comprise forming an opening 210 comprising a slit and using the laser to control the curvature on either side of the slit. For example, the laser may be configured to form different radii of curvature on opposing edges of the slit or hole. In other words, the method may comprise a step of forming a curvature having a first radius on one edge of the slit and a step of forming a curvature having a second radius on an opposing edge of the slit, wherein the first radius is different to the second radius.

The method may further comprise forming at least one connection portion in the component for attachment to another part. The method may comprise forming the plate region (e.g. plate 40) as described above and/or forming at least one opening 210 and/or channel 201 in the plate region. The method may comprise forming at least one thermal conditioner and/or thermal insulator as described above. For example, the method may comprise forming at least one thermal channel 212, e.g. adjacent to at least part of the channel 201, or elsewhere in the component. For example, the thermal channel 212 may be formed surrounding at least part of the channel 201. Preferably, the thermal channel 212 is in fluid communication with an inlet and/or outlet configured to apply a vacuum or insulating fluid or conditioning fluid within the thermal channel 212. The method may further comprise coating 230 at least a portion of a surface of the fluid handling structure 12. In particular, the method may comprise coating at least a portion of a surface of the component.

In the above embodiments, the fluid handling structure 12 is formed of a single component (i.e. is monolithic). However, this is not a necessity. The fluid handling structure 12 may be formed of multiple components, i.e. multiple component parts. In other words, the fluid handling structure 12 may be formed by multiple layers, for example as shown in Figure 5. For example, the component described above may be a first component part 12a and the fluid handling structure 12 may comprise a second component part 12b comprising at least one further channel in fluidic communication with the at least one channel 201.

For example only, the first component part 12a may have openings 210 in a surface which is configured to face the surface of a substrate W and/or a substrate support WT supporting the substrate W during use. The first component part 12a may comprise at least one channel 201 within the component in fluidic connection with each opening 210. Thus, each opening 210 may have a channel 201 via which fluid can be supplied and/or extracted. The second component part 12b may comprise at least one channel which, when the first component part 12a and second component part 12b are joined together, is in fluidic communication with at least one channel 201 of the first component part 12a. The second component part 12b may comprise openings 200 for fluidic communication external to the fluid handling structure 12/component. Thus, the second component part 12b may provide fluidic connections for supplying and/or extracting fluid from the openings 210 (e.g. via openings 200).

The second component part 12b may be made of the same material as the first component part 12a, or a different material. The second component part 12b may be made of glass and/or crystal. The second component part 12b may be made of fused silica, silicon, borosilicate, sapphire (e.g. crystalline sapphire), or Yttrium aluminium garnet (YAG), ULE, BF33, D263, NK5, SF2, Zerodur, AF45, Eagle XG, quartz. It may be preferable for the first component 12a and the second component 12b to be formed of the same material, or at least a material with similar or the same coefficient of thermal expansion (CTE) which may be beneficial in reducing or minimising bending and/or internal stresses.

The multiple components (e.g. the first component part 12a and the second component part 12b) may be joined together by bonding. Bonding may include direct or fusion bonding, glass frit bonding, anodic bonding etc.. Thus, the two component parts may together form the fluid handling structure 12. In particular, the first component part 12a and second component part 12b may be joined together by adhesive. Any appropriate adhesive may be used. For example, the bonding may comprise applying adhesive to at least one facing surface of the first component part 12a and/or the second component part 12b.

Additional components may be provided. The additional components may be joined to form the fluid handling structure 12 as described in relation to the first component part 12a and the second component part 12b, and may be of any appropriate material. It is noted that any components provided further to the first component part 12a, e.g. the second component part 12b or any additional components, may include at least some of the openings 210 and/or channels 201 described above. Any channels included in any further component parts may be in fluidic communication with channels in other components. Any further components may have features described in relation to the first component part 12a, e.g. at least one opening 210 with different radii of curvature on the edges and/or at least one connection portion.

Although the fluid handling structure 12 may be formed with two component parts by using selective laser etching, at least one alternative method may be used.

In an embodiment, a method is provided of manufacturing a fluid handling structure 12 for an immersion lithographic apparatus, the fluid handling structure 12 configured to confine immersion liquid to an immersion space 11 between a bottom surface of the fluid handling structure 12 and a surface of a substrate W and/or a substrate support WT supporting the substrate W. In this embodiment, the method comprises providing a first component part 12a and a second component part 12b (e.g. as described above). In this embodiment, each of the first component part 12a and the second component part 12b is solid and is made of glass or crystal, for example silicon. Furthermore, the method comprises using MEMS techniques to define an opening 210 (e.g. a first opening) in a surface of the first component part 12a and a channel 201 (e.g. a first channel) in the first component part 12a extending from the opening 210, and to define a further opening (e.g. a second opening, e.g. an opening 200 in a top surface, or an alternative opening 210 in the bottom surface) in a surface of the second component part 12b and a further channel (e.g. a second channel such as internal channels 202) in the second component part 12b extending from the second opening. MEMS are microelectromechanical system. MEMS techniques may otherwise be generally referred to as lithography techniques. The MEMS techniques may comprise selectively applying resist to a surface of the first component part 12a and a surface of the second component part 12b, and exposing the surfaces on which the resist is positioned. The method may comprise etching to remove material from the first component part 12a to form the opening 210 and the channel 201 and to remove material from the second component part 12b to form the further opening and the further channel, and bonding the first component part 12a and the second component part 12b to provide a component for forming the fluid handling structure 12, wherein the channel 201 and the further channel are in fluidic communication. Thus, this method provides an alternative method to the selective laser etching, however, works in a similar way of using an initial step to alter material in a solid component part (in this case using lithographic techniques), and then etching away the altered material to form the openings/channels (and thus, has many of the advantages described above). Thus, the present embodiment may be used to obtain the same variations as described above for the SLE embodiments (except that the component is not monolithic in the present embodiment). In this embodiment, the component is formed by layers, i.e. component parts (as in some of the SLE embodiments) which are then combined when processed to form channels 201 (e.g. preferably mm- and micro-meter sized channels, preferably with <1micrometer precision and preferably with extreme cleanliness). Wet etching and/or dry etching may be used.

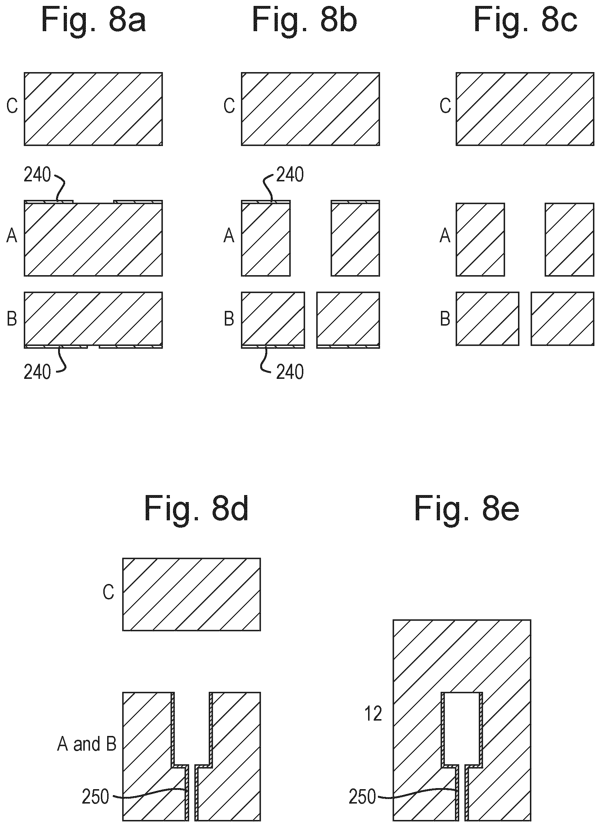

An example of MEMS techniques which may be used is shown in figures 8a-e. As shown in Figure 8a, initially several components (in this case 3 components, A, B and C) are provided. Each component is a solid block of material. In a first step (shown in Figure 8a), resist 240 is selectively applied to at least one surface of at least one component. In Figure 8A, resist 240 is applied to an upper layer of component A, leaving a gap (which is to form a first part of a channel) and resist 240 is applied to a lower layer of component B, leaving a gap (which is to form a second part of a channel). The first and the second components A, B are exposed and the resist 240 is developed. Thus, the first step involves using lithography techniques to effectively form a pattern on the relevant component(s). In a second step (shown in Figure 8b), etching (e.g. (cryo)DRIE etching) is carried out to remove material corresponding to the gaps in the resist 240. In a third step (shown in Figure 8c), the resist 240 is stripped from the first and the second components A, B. This may comprise completely stripping the first and the second components A, B. In a fourth step (shown in Figure 8d), the first and second component A, B are bonded. As shown in Figure 8d, the first part of the channel and the second part of the channel are aligned (i.e. are in fluidic communication) when the first and second components A, B are bonded. Optionally, in the fourth step, a coating (not shown) is applied to the channel internally (although this may be beneficial, it is not a necessity and the channel may be a full bare surface). In a fifth step (as shown in Figure 8e), the third component C is bonded to the other components (i.e. to the first and second components A, B).

Various MEMS techniques are available to shape the final microfluidic structure (i.e. the openings and channels which may be formed in the fluid handling structure 12). The specific method/techniques may be chosen depending on desired shape and surface finish. For vertical walls, for example, DRIE (deep reactive ion etching) via the so-called Bosch process or cryo-DRIE can be used. The former leaves scallops at the side walls with characteristic size depending on the etch rate and switching-time passivation and etch. However, techniques exist to reduce or eliminate these scallops via post treatments resulting in very smooth vertical walls. For example, post treatments may include any combination of thermal oxidation, polysilicon deposition and/or wet etching (as well as, or alternatively, use of other appropriate techniques). Etch stops such as a buried oxide layer (using e.g. silicon-on-insulator (SOI), or doping) can be used to have well defined depths of the channel. Anisotropic wet etching can be used to use the intrinsic crystallographic planes of the material to form the desired microfluidic geometry. The planes result from the anisotropic character of etch-rates depending on crystal orientation (i.e. depending on the crystallographic alignment between mask and sample). Hence resulting in extremely smooth surface finish and very precise angles (fixed by the used crystal structure) between developed facets (other naming faceting). Isotropic wet etching (e.g. of Si or glass) results in very smooth rounded corners in the microfluidic geometry resulting from the isotropic nature of etching. If this is the single etch method used, the radius of curvature scales with etch depth. It can also be used as a post-step to introduce fillet-like aspect to channels. It is noted that such MEMS related techniques are well known (even though they may not have been used for manufacturing fluid handling structures 12 as disclosed herein before. Thus, aspects and variations of these techniques are known to the skilled person, for example, fabrication of at least one channel may be based on any or all of at least "HIGH PRESSURE: A CHALLENGE FOR LAB-ON-A-CHIP TECHNOLOGY", by Fernando Benito López (https://doi.org/10.3990/1.9789036524827), "Etching technology for chromatography microchannels", R.W. Tjerkstra et al. (https://doi.org/10.1016/50013-4686(97)00193-X),A versatile surface channel concept for microfluidic applications", Dijkstra et al. (10.1088/0960-1317/17/10/007) which are hereby incorporated by reference in their entirety. Additionally or alternatively, an overview of example methods can be found in "Handbook of Silicon Based MEMS Materials and Technologies" - A volume in Micro and Nano Technologies, Third Edition, 2020 (https://doi.org/10.1016/C2018-0-01845-9) which is hereby incorporated by reference in its entirety.

It is noted that the components formed by this method (i.e. using MEMS techniques and etching) may be made of silicon, which broadens the design space/has different thermal properties to some of the other materials used with the LSE method.

It will be understood that embodiments of the present invention may be beneficial in improving fluid handling structure manufacturing, in particular due to using selective laser etching techniques. In particular, such processes are beneficial in providing quick manufacturing processes whilst also providing accurate formation of at least one small opening/channel. Overall, some of the main benefits may relate to improved versatility of design/enabling design space, high precision, low lead times, chemical inertness and/or thermal insulation.

In arrangements where openings 210 are provided, the openings 210 may be: a series of discrete openings; or elongate openings such as grooves; or a combination of elongate openings and small discrete openings. Discrete openings may be circular or rectangular (or any appropriate shape). The size, number and spacing of the openings 210 may be varied around the fluid handling structure 12 in order to provide different supply rates in different locations.

The supply of fluid (e.g. gas, liquid or both) through any supply openings may be controllable individually or in groups. Control of the fluid supplied through openings may be dependent upon the movement of the substrate W relative to the fluid handling structure 12, e.g. dependent on the direction and/or speed of the substrate W. For example, the fluid supplied through supply openings may be turned on only at the receding side of the fluid handling structure 12 (or alternatively could be turned on only at the advancing side). For example, the rate of fluid supply through supply openings may be increased with increased speed of movement of the substrate W relative to fluid handling structure 12 (or alternatively could be decreased as desired). Such arrangements ensure that leakage of the fluid (e.g. gas) is minimised in areas where otherwise it would be highest.

The present invention may provide a lithographic apparatus. The lithographic apparatus may have any/all of the other features or components of the lithographic apparatus as described above. For example, the lithographic apparatus may optionally comprise at least one or more of a source SO, an illumination system IL, a projection system PS, etc.

Specifically, the lithographic apparatus may comprise the projection system PS configured to project the radiation beam B towards the region of the surface of a substrate W.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Where the context allows, embodiments of the invention may be implemented in hardware, firmware, software, or any combination thereof. Embodiments of the invention may also be implemented by instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate W) or mask (or other patterning device). These apparatus may be generally referred to as lithographic tools. Such a lithographic tool may use ambient (non-vacuum) conditions.

Although specific reference may have been made above to the use of embodiments of the invention in the context of optical lithography, it will be appreciated that the invention, where the context allows, is not limited to optical lithography.

Embodiments of the present invention are further described in the following numbered clauses:
1. A fluid handling structure for an immersion lithographic apparatus, the fluid handling structure configured to confine immersion liquid to an immersion space between a bottom surface of the fluid handling structure and a surface of a substrate and/or a substrate support supporting the substrate, comprising a component comprising:
   at least one opening formed in a surface of the component and configured to supply or extract the immersion liquid;
   at least one channel in fluidic communication with the opening is defined in the component;
   wherein the component is made of glass and/or crystal.
2. The fluid handling structure of clause 1, wherein the component is made of fused silica, silicon, borosilicate, sapphire, or Yttrium aluminum garnet (YAG), ULE, BF33, D263, NK5, SF2, Zerodur, AF45, Eagle XG, quartz.
3. The fluid handing structure of any one of the preceding clauses, wherein a diameter of the at least one opening is greater than or equal to approximately 5 micrometer.
4. The fluid handling structure of any one of the preceding clauses, wherein the at least one opening comprises a slit and a radius of curvature on one edge of the slit is different to a radius of curvature on an opposing edge of the slit.
5. The fluid handling structure of any one of the preceding clauses, further comprising at least one connection portion in the component for attachment to another part.
6. The fluid handling structure of clause 5, wherein the at least one connection portion comprises a threaded opening defined on an outer surface of the component.
7. The fluid handling structure of any one of the preceding clauses, wherein the component comprises a plate region wherein the thickness of the plate region is between approximately 0.2 mm and 20 mm, preferably wherein the plate region comprises at least one opening and corresponding channel.
8. The fluid handling structure of any one of the preceding clauses, wherein the component comprises at least one thermal insulator and/or thermal conditioner.
9. The fluid handling structure of clause 8, wherein the thermal insulator and/or thermal conditioner surrounds at least part of the at least one channel.
10. The fluid handling structure of clause 8 or 9, wherein the thermal insulator and/or thermal conditioner comprises a thermal channel in fluidic communication with an inlet and/or outlet configured to apply a vacuum, conditioning fluid, or insulating fluid within the thermal channel.
11. The fluid handling structure of any one of the preceding clauses, wherein at least a portion of a surface of the fluid handling structure is provided with a coating.
12. The fluid handling structure of any one of the previous clauses, comprising multiple openings, each with a corresponding channel communicating with the opening and defined in the component, wherein at least one opening is configured to supply immersion liquid and at least one opening is configured to extract immersion liquid.
13. The fluid handling structure of any one of the preceding clauses, wherein the at least one opening and the at least one channel are formed using selective laser etching.
14. The fluid handling structure of any one of the preceding clauses, wherein the component is monolithic.
15. The fluid handling structure of any one of clauses 1 to 12, wherein the at least one opening and the at least one channel are formed using MEMS techniques in combination with wet and/or dry etching.
16. The fluid handling structure of any one of clauses 1 to 13 and 15, wherein the component is a first component part comprising the at least one opening and the at least one channel, and the fluid handling structure comprises a second component part comprising a further opening and a further channel in fluidic communication with the at least one channel.
17. The fluid handling structure of clause 16, wherein the second component part is glass and/or crystal.
18. The fluid handling structure of clause 16 or 17, wherein the first component part and the second component part are joined together by bonding.
19. The fluid handling structure of clause 18, wherein the first component part and second component part are joined together by adhesive.
20. The fluid handling structure of any one of the preceding clauses, wherein the component is transparent, and the fluid handling structure further comprises a sensor configured to take a measurement through the component.
21. A method of manufacturing a fluid handling structure for an immersion lithographic apparatus, the fluid handling structure configured to confine immersion liquid to an immersion space between a bottom surface of the fluid handling structure and a surface of a substrate and/or a substrate support supporting the substrate, the method comprising:
   providing a first component part and a second component part, wherein each of the first component part and the second component part is solid and is made of glass or crystal;
   using MEMS techniques to define an opening in a surface of the first component part and a channel in the first component part extending from the opening, and to define a further opening in a surface of the second component part and a further channel in the second component part extending from the second opening;
   etching to remove material from the first component part to form the opening and the channel and to remove material from the second component part to form the further opening and the further channel;
   bonding the first component part and the second component part to provide a component for forming the fluid handling structure, wherein the channel and the further channel are in fluidic communication.
22. The method of clause 21, wherein the first component part and the second component part are made of silicon.
23. A method of manufacturing a fluid handling structure for an immersion lithographic apparatus by selective laser etching, the fluid handling structure configured to confine immersion liquid to an immersion space between a bottom surface of the fluid handling structure and a surface of a substrate and/or a substrate support supporting the substrate, the method comprising:
   providing a component for forming the fluid handling structure, wherein the component is solid and is made of glass or crystal,
   using a laser to define an opening in a surface of the component and a channel within the component extending from the opening;
   chemical etching to remove material from within the component to form the opening and the channel.
24. The method of clause 23, wherein the component is made of fused silica, borosilicate, sapphire, or Yttrium aluminum garnet (YAG), ULE, BF33, D263, NK5, SF2, Zerodur, AF45, Eagle XG, quartz.
25. The method of clause 23 or 24, wherein the component is monolithic.
26. The method of clause 23 or 24, wherein the component is a first component part comprising the at least one opening and the at least one channel, and the fluid handling structure comprises a second component part comprising a further opening and a further channel in fluidic communication with the at least one channel.
27. The method of clause 26, further comprising bonding the first component part and the second component part .
28. The method of clause 21, 22 or 27, wherein the bonding comprises applying adhesive to at least one facing surface of the first component part and the second component part.
29. The method of any one of the clauses 21 to 28, wherein a diameter of the opening is greater than or equal to approximately 5 micrometres.
30. The method of any one of the clauses 21 to 29, wherein the opening comprises a slit and the step of defining the opening is used to control the curvature on either side of the slit.
31. The method of clause 30, wherein the step of defining the opening is configured to form different radii of curvature on opposing edges of the slit.
32. The method of any one of the clauses 21 to 31, further comprising forming at least one connection portion in the component for attachment to another part.
33. The method of clause 32, wherein the at least one connection comprises a threaded opening defined on an outer surface of the component.
34. The method of any one of the clauses 21 to 33, wherein the component comprises a plate region wherein the thickness of the plate region is between approximately 0.2 mm and 20 mm, preferably the method further comprises forming at least one opening and corresponding channel within the plate region.
35. The method of any one of the clauses 21 to 34, further comprising forming at least one thermal channel adjacent to at least part of the channel.
36. The method of clause 35, wherein the thermal channel is formed surrounding at least part of the channel.
37. The method of clause 35 or 36, wherein the thermal channel is in fluidic communication with an inlet and/or outlet configured to apply a vacuum, conditioning fluid, or insulating fluid within the thermal channel.
38. The method of any one of clauses 21 to 37, further comprising coating at least a portion of a surface of the fluid handling structure.

## Claims

1. A fluid handling structure for an immersion lithographic apparatus, the fluid handling structure configured to confine immersion liquid to an immersion space between a bottom surface of the fluid handling structure and a surface of a substrate and/or a substrate support supporting the substrate, comprising a component comprising:
at least one opening formed in a surface of the component and configured to supply or extract the immersion liquid;
at least one channel in fluidic communication with the opening is defined in the component;
wherein the component is made of glass and/or crystal.

2. The fluid handling structure of claim 1, wherein the component is made of fused silica, silicon, borosilicate, sapphire, or Yttrium aluminum garnet (YAG), ULE, BF33, D 263, N-K5, SF2, Zerodur, AF45, Eagle XG, quartz.

3. The fluid handing structure of claim 1 or 2, wherein a diameter of the at least one opening is greater than or equal to approximately 5 micrometer, and/or wherein the at least one opening comprises a slit and a radius of curvature on one edge of the slit is different to a radius of curvature on an opposing edge of the slit, and/or further comprising at least one connection portion in the component for attachment to another part, desirably wherein the at least one connection portion comprises a threaded opening defined on an outer surface of the component.

4. The fluid handling structure of any of the preceding claims, wherein the component comprises a plate region wherein the thickness of the plate region is between approximately 0.2 mm and 20 mm, preferably wherein the plate region comprises at least one opening and corresponding channel, and/or wherein the component comprises at least one thermal insulator and/or thermal conditioner, desirably wherein the thermal insulator and/or thermal conditioner surrounds at least part of the at least one channel, and/or desirably wherein the thermal insulator and/or thermal conditioner comprises a thermal channel in fluidic communication with an inlet and/or outlet configured to apply a vacuum, conditioning fluid, or insulating fluid within the thermal channel.

5. The fluid handling structure of any of the preceding claims, wherein at least a portion of a surface of the fluid handling structure is provided with a coating, and/or comprising multiple openings, each with a corresponding channel communicating with the opening and defined in the component, wherein at least one opening is configured to supply immersion liquid and at least one opening is configured to extract immersion liquid, and/or wherein the component is transparent, and the fluid handling structure further comprises a sensor configured to take a measurement through the component.

6. The fluid handling structure of any of the preceding claims, wherein the at least one opening and the at least one channel are formed using selective laser etching, and/or wherein the component is monolithic.

7. The fluid handling structure of any of claims 1-5, wherein the at least one opening and the at least one channel are formed using MEMS techniques in combination with wet and/or dry etching.

8. The fluid handling structure of any of claims 1-5 and 7, wherein the component is a first component part comprising the at least one opening and the at least one channel, and the fluid handling structure comprises a second component part comprising a further opening and a further channel in fluidic communication with the at least one channel, desirably wherein the second component part is glass and/or crystal, and/or desirably wherein the first component part and the second component part are joined together by bonding, desirably wherein the first component part and second component part are joined together by adhesive.

9. A method of manufacturing a fluid handling structure for an immersion lithographic apparatus by selective laser etching, the fluid handling structure configured to confine immersion liquid to an immersion space between a bottom surface of the fluid handling structure and a surface of a substrate and/or a substrate support supporting the substrate, the method comprising:
providing a component for forming the fluid handling structure, wherein the component is solid and is made of glass or crystal,
using a laser to define an opening in a surface of the component and a channel within the component extending from the opening;
chemical etching to remove material from within the component to form the opening and the channel.

10. The method of claim 9, wherein the component is made of fused silica, borosilicate, sapphire, or Yttrium aluminum garnet (YAG), ULE, BF33, D263, NK5, SF2, Zerodur, AF45, Eagle XG, quartz, and/or wherein the component is monolithic.

11. The method of claim 9 or 10, wherein the component is a first component part comprising the at least one opening and the at least one channel, and the fluid handling structure comprises a second component part comprising a further opening and a further channel in fluidic communication with the at least one channel, desirably further comprising bonding the first component part and the second component part, desirably wherein the bonding comprises applying adhesive to at least one facing surface of the first component part and the second component part.

12. The method of any of claims 9-11, wherein a diameter of the opening is greater than or equal to approximately 5 micrometres, and/or wherein the opening comprises a slit and the step of defining the opening is used to control the curvature on either side of the slit, desirably wherein the step of defining the opening is configured to form different radii of curvature on opposing edges of the slit.

13. The method of any of claims 9-12, further comprising forming at least one connection portion in the component for attachment to another part, desirably wherein the at least one connection comprises a threaded opening defined on an outer surface of the component.

14. The method of any of claims 9-13, wherein the component comprises a plate region wherein the thickness of the plate region is between approximately 0.2 mm and 20 mm, preferably the method further comprises forming at least one opening and corresponding channel within the plate region, and/or further comprising forming at least one thermal channel adjacent to at least part of the channel, and/or wherein the thermal channel is formed surrounding at least part of the channel, and/or further comprising coating at least a portion of a surface of the fluid handling structure.

15. The method of claim 14, wherein the thermal channel is formed surrounding at least part of the channel, and/or wherein the thermal channel is in fluidic communication with an inlet and/or outlet configured to apply a vacuum, conditioning fluid, or insulating fluid within the thermal channel.
